# EUROPEAN PATENT SPECIFICATION

(11) **EP 0 304 182 B1**
(45) Date of publication and mention of the grant of the patent: **26.05.1993**
(21) Application number: 88306994.0
(22) Date of filing: 29.07.1988
(51) Int. Cl.: G02B 6/42

(54) **Fibre tailed opto-electronic transducer**
Mit einem Fiberende versehener optoelektronischer Wandler
Transducteur opto-électronique avec un raccord en fibre optique

(30) Priority: 19.08.1987 GB 8719590
(43) Date of publication of application: 22.02.1989
(73) Proprietor: NORTHERN TELECOM LIMITED, Montreal, Quebec H2Y 3Y4 (CA)
(72) Inventor: Turner, Andrew Stephen, Paignton Devon TQ4 7SW (GB); Hext, Trevor Edwin John, Newton Abbot Devon (GB); Janssen, Adrian Perrin, Exwick Exeter (GB)
(74) Representative: Dennis, Mark Charles

(56) References cited:
- EP-A- 0 181 532
- EP-A- 0 183 302
- EP-A- 0 183 857
- DE-A- 3 413 748
- GB-A- 2 184 289
- US-A- 4 168 883
- PATENT ABSTRACTS OF JAPAN vol. 8, no. 55 (P-260)(1492) 13 March 1984; & JP -A - 58 205119, 30.11.1983
- JOURNAL OF LIGHTWAVE TECHNOLOGY vol. LT-4, no. 9, September 1986, pages 1407-1413, New York, USA: "Laser Diode Module for Single-Mode Fiber Based on New Confocal Combination Lens Method"

## Description

This invention relates to fibre-tailed optoelectronic transducers, particularly to the packaging of such transducers that are optically emissive such as lasers. Such lasers are normally provided with optical tails for connection in an optical fibre transmission system. An example is disclosed in the specification of our British Patent 2124402B. That specification describes a relatively complex structure.

European Patent Application 0181532 discloses a fibre-to-fibre connection in which the welding is effected within a circle around the coupling surfaces to minimise distortion. As exemplified in Figs. 19 and 20 a submount for the laser and fibre is split in two halves and welded at the edges at the point Sp.

The main disadvantage of this arrangement is the split submount which is not hermetically sealed, so the final assembly needs to be built into a DIL package, or similar to that shown in our earlier patent British 2124402B mentioned earlier, in order to obtain an hermetically sealed arrangement.

Secondly, the solution to the welding problem encountered is not necessarily satisfactory because welding points still occur at places where stress due to welding will cause distortion. This is particularly so at the upper welding point in Fig. 20 where shrinkage upon cooling will tend to open up the gap Kf16 until the lower welding point has been completed.

Another fibre-tailed laser diode package is described in GB 2184289A. This has a semiconductor laser can secured in one end of a holder to the other end of which is secured, by way of a flange, a fibre tail termination. The specification refers to the problem of light being reflected from the end of the fibre back into the laser where it can disrupt laser operation. It mentions the possibility of overcoming this problem merely by arranging for the fibre to terminate in an oblique facet but suggests that this approach is unpractical because little of the axially incident light would be launched into the fibre. The present invention discloses how this problem can be overcome by arranging for the light to be obliquely incident at an angle chosen so that the refracted light is axial, and hence launch efficiency substantially optimised.

It is an object of the present invention to provide a technique for providing an hermetically-sealed optoelectronic transducer with a fibre tail in a simple, reliable and cost effective way, and furthermore one in which reflection from the nearer end facet of the fibre back into the transducer is also suppressed in a simple reliable and cost effective way that does not significantly impair coupling efficiency.

According to the present invention there is provided a fibre-tailed optical transmitter package including a windowed hermetically sealed container containing an optically emissive electro-optical transducer, a holder in which said container is secured, and an optical fibre termination body in which one end portion of an optical fibre tail is inserted and secured, the axis of said end portion defining the axis of the fibre termination body, which body is provided with a wall to which the fibre termination body axis extends normally, by which wall the fibre termination body is secured by a plurality of welds to a co-operating wall of the holder, wherein one of said walls is formed by a flange, and wherein the normal to the end face of said end portion of the optical fibre tail is inclined at an angle to the fibre termination axis, characterised in that the optical emission of the transducer passes obliquely through the window of the container to be obliquely incident upon said inclined end face of the fibre tail.

There follows a description of transmitter packages embodying the invention in a preferred form. The description refers to the accompanying drawings in which:-
Figure 1 depicts a hermetically sealed transducer can and its holder,
Figure 2 depicts a transmitter package embodying the invention in a preferred form, the package comprising the can and holder assembly of Figure 1 together with a fibre tail termination,
Figures 3 and 4 depict longitudinal sections of alternative forms of fibre tail terminations depicted in Figure 2,
Figure 5 depicts a part sectioned view of the can of Figure 1 and its contents,
Figure 6 depicts a further view of the contents of the can of Figure 1,
Figure 7 depicts schematically apparatus for positioning and welding the fibre tail termination to the holder of the can and holder assembly,
Figure 8 shows an end view of the welded flange of the fibre tail termination, and
Figure 9 is a diagram depicting the ray path from transducer to fibre of the package.

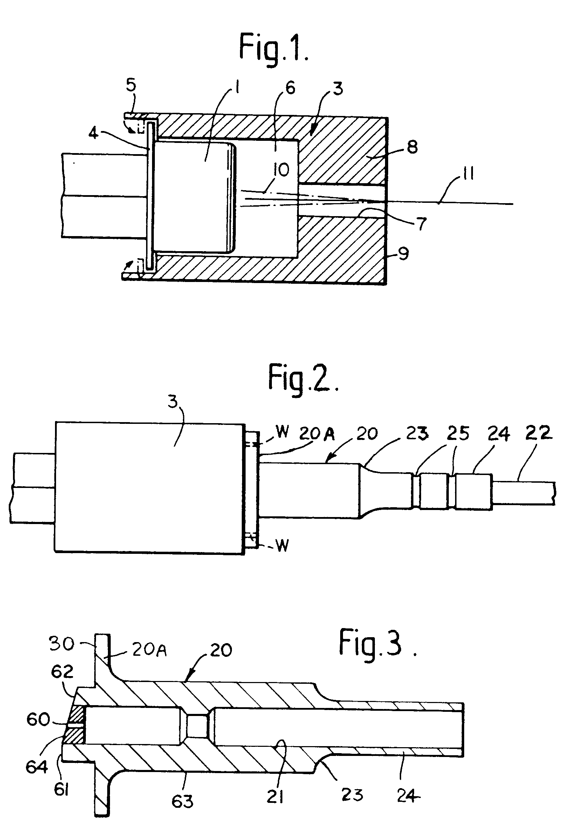

Referring to Fig. 1 a semiconductor laser diode is hermetically sealed in a container comprising a T018 type can 1, with a window sealed in the forward end of the can. The can 1 is fitted into a stainless steel holder 3 which is configured to fit the can 1. The can 1 has a peripheral base region 4 which is held by turning over a rim portion 5 of the holder 3, as indicated by the arrows, and the broken lines show the position of the rim 5 after it has been turned over.

The holder 3 has a hollow interior 6 to accommodate the body of the can 1 and a narrow bore 7 through which the light beam 10 from the lens 2 will travel. The base 7 extends through a thick flange 8 and the end-face 9 is exactly normal to the axis 11 of the device.

As mentioned the T018 can is only one example of a hermetic sealing container. Other hermetic sealing containers could be used, in which case the precise configuration of the left hand portion of the termination 3 would be modified accordingly to fit such containers and be secured thereto in similar fashion.

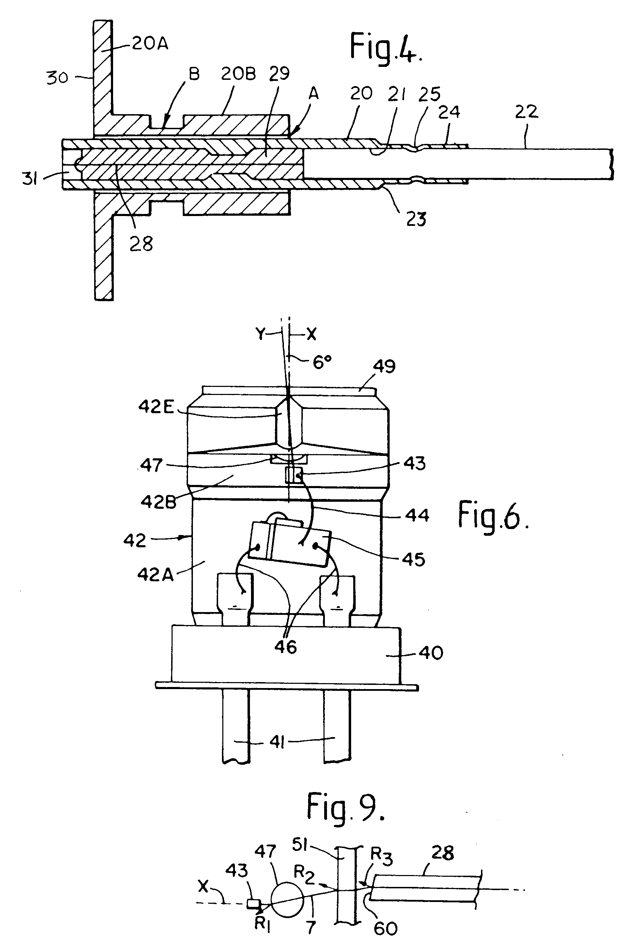

Figure 2 depicts the can and holder assembly of Figure 1 together with a fibre tail termination 20 which has a thin flange 20A welded at several locations W to the end face 9 of the holder 3. Two alternative forms of fibre termination are depicted respectively in longitudinal section in Figures 3 and 4. Both terminations of these two fibres have a tubular stainless steel body with a bore 21 dimensioned to receive one end of an optical fibre tail 28, which may be a monomode fibre, encased in a plastics coating 22. The coating 22 typically has an external diameter of about 1mm. In each case the axis of the tube extends normally with respect to the plane of the flange. Designating the axis of the tube as the z-axis, it will be apparent that, until the welds W are made, the position of the end of the fibre 28 can be adjusted in the xy plane by sliding the face 30 of the flange 20A across the end surface 9 of the holder 3. The fibre termination of Figure 4 is primarily distinguished from that of Figure 3 in that the Figure 4 termination also allows adjustment in the z-direction by virtue of its two-part construction in which its flange 20A is carried on an outer tubular portion 20B which is slideable along the outer surface of the inner tubular portion 20 until such time as they are welded together at A and B.

The end of the fibre 28 threads the central aperture of a jewel 31 which is located at the left-hand end of the fibre termination so as to hold that end close to the axis of the termination and the space between the left-hand end of the plastic coating 22 on the fibre 28 and the jewel is filled with epoxy resin 29. The tube 20 is stepped at 23 so that the right-end end portion 24 has a wall thickness small enough to enable this portion to be lightly coupled at 25 around the plastics coating 22 on the fibre 28 before the epoxy resin 29 has been cured.

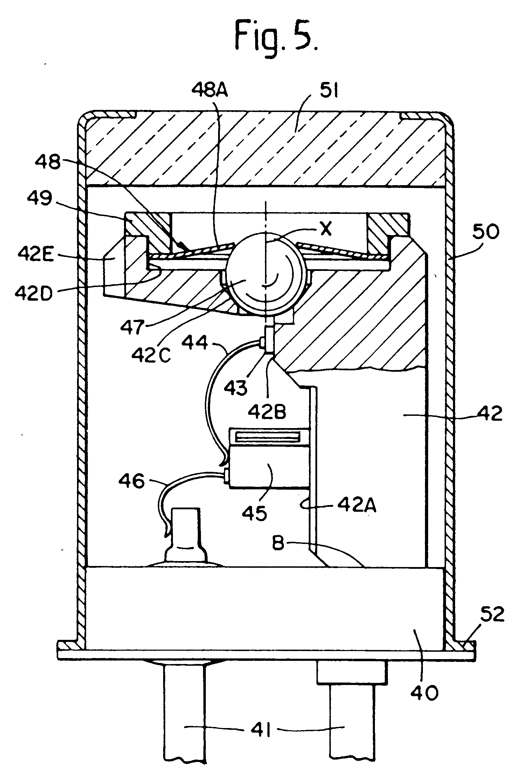

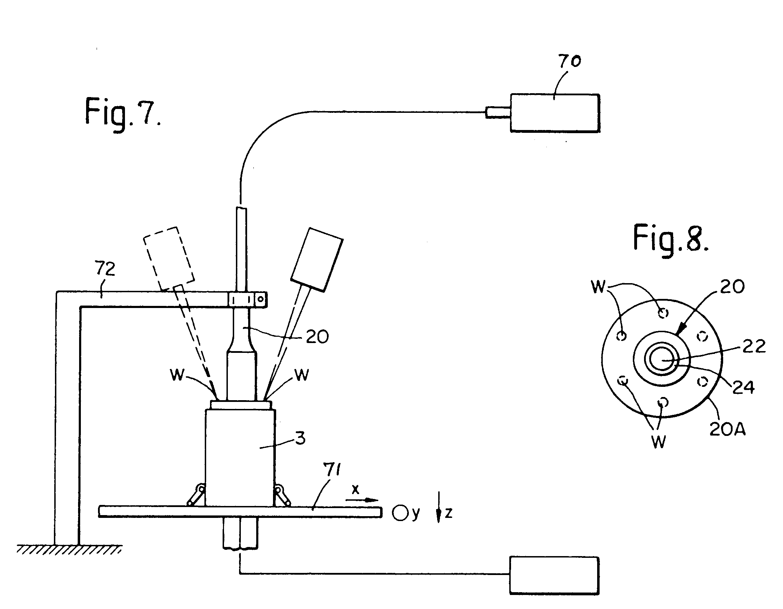

If the end face 60 of the fibre 28 were to terminate in a plane to which the fibre axis is normal then maximum coupling efficiency of light from the transducer can 1 into the fibre 28 occurs when this light is arranged to be incident normally upon that end face 60. A disadvantage of this arrangement is that any normally incident light that is not launched into the fibre 28, but is reflected, is reflected back into the transducer. If the transducer is a semiconductor laser such reflection can disrupt its operation. Accordingly the end face 60 of the fibre 28, together with the end face 64 of the jewel 31 and a portion 62 of the end face 61 of the termination 20, is lapped to a predetermined oblique angle so that maximum coupling efficiency into the fibre is at an angle of incidence upon end face 60 inclined at an angle to normal incidence. (This oblique angle is illustrated in Figure 3, in Figure 4 it does not show up because of the plane of sectioning chosen for this figure.)
The can 1 of Figure 1 and its contents are shown in greater detail in Figures 5 and 6. The TO18 can has a base 40 made of KOVAR (RTM) through which are hermetically sealed four electrical connection pins 41. The base 40 is gold plated.

A unitary block 42 is precision cast from metal and defines a mounting platform 42A for a monitor photodiode and a mounting pedestal 42B for a laser chip 43 in which the emission line is denoted by X. A monitor photodiode 45 is soldered onto the pedestal 42A. Connection such as 46 are made to the pins 41.

The block 42 also defines a fixed mounting surface 42C for a spherical lens 47 of, in this embodiment, 1mm diameter. The surface 42C is a frusto-conical seat and the lens is held in place in the seat by a spring holder 48 which has several radial fingers 48A which urge the lens 47 into its seat.

The axis X of the laser emission is level with the central axis of the lens as viewed in Figure 5.

A collar 49 holds the spring holder 48 in position against the lens 47 and is soldered in position in the circular recess 42D defined by the mounting block 42. Alternatively the spring holder could have radially-projecting sprags so it can be push-fitted into the circular recess 42D, the sprags biting into the wall 42D, thus eliminating the need for the collar 49.

An hermetic sealing metal cover 50 having a planar glass window 51 is sealed at rim 52 to the header 40.

The hermetic package thus formed is secured into the flanged casing 8 as previously described with reference to Figure 1.

The package is assembled as follows. The body 42 is brazed at B to the header 40. The body 42 has a cylindrical surface centred on the axis X and the body is brazed so that the X axis is concentric with the central axis of the header 40, which is also circular.

The lens 47 is inserted in the seat 42C and held in place by the spring holder 48 and collar 49.

The laser chip 43 is then soldered to the pedestal 42B either directly or via a heat spreader (not shown) so that the emitted beam is laterally offset from the axis X as viewed in Figure 6. In this way the lens 47 not only focusses the beam at a point beyond the window 51 and coinciding substantially with the end face of the fibre in the fibre termination, but also deflects the beam so that it emerges from the package at a small angle to the X-axis, approximately 6°, as indicated by the axis Y in Figure 6.

A marker 42E is used as an angular alignment device, co-operating with another marker (not shown) on the flange 20A of the termination 20 to align the can with the fibre at a later stage of manufacture so that the beam Y meets the end face of the fibre at the correct angle.

The monitor photodiode 45 is soldered onto pedestal 42A and connected with the pins 41 and the laser 43.

The assembly is tested and then the cover 50 is hermetically sealed to the header at rim 52.

The hermetic package is then placed in the flanged casing 8 as previously described with reference to Figure 1, and held by turning over the rim 5 to hold the package captive.

It should be understood that the header 40 acts to provide a reference datum for the beam axis Y, in terms of the plane of the circle of the flange 52, the axis X being the central axis of the circle and being at 90° to the plane of the flange 52.

The flanged casing 8 is therefore coaxially aligned with the axis X and so the emerging beam axis Y is at the same angle (about 6°) to the normal to the face 9 of flange 8.

Referring now to Figure 7, the fibre tail termination 20 is joined to the holder 3 using a laser welder in conjunction with an x-y positioning table 70. The termination is clamped to a fixed support 72, while the holder 3 is clamped to the positioning table 70 with the appropriate relative angular orientation as determined by the alignment of marker 42E with the co-operating marker on the flange 20A. The laser 43 is powered and the a mount of its light launched into the fibre tail is monitored with a photodetector 71. The output of the photodetector 71 is monitored while lateral movements of the precision x-y positioning table 70 are performed in a systematic manner until the output has been maximised indicating optimum alignment of fibre with respect to the laser. At this point the laser welder is operated to stake the thin flange 20A by welds W to the holder 3 so as to secure the two parts together in permanent alignment. If the fibre tail termination is of the two-part kind illustrated in Figure 4 then the x and y movements of the positioning table 70 are accompanied by z movements of the tube 20 in its outer part 20B. When the x, y and z positions have been optimised, laser welds are made at point A of Figure 4. This, however may provide a fulcrum for future movement and consequential alignment loss, and so this risk is reduced by further welds at point B before making any necessary minor realignment of the x and y positions, to correct for misalignment caused by freezing of the weld pools, prior to making the welds W. The welds W are preferably performed at regular intervals around the flange 20A as depicted in Figure 8.

Figure 9 depicts the ray path from the laser 43 to the end of the optical fibre 28. This arrangement allows the light to be incident upon the end face 60 at the optimum angle for launching that light into the fibre while at the same time ensuring that any light R₃ reflected at this face is not directed back into the laser 43, but is directed elsewhere, as also is any light R₁, reflected at the front facet of lens 47 and any light R₂ reflected at the window 51. The angle between the axis and the normal to the end face 60 is typically about 15°. The angular orientation of the fibre in relation to the laser can is tolerant within ± 5°.

## Claims

1. A fibre-tailed optical transmitter package including a windowed (51) hermetically sealed container (1) containing an optically emissive electro-optical transducer (43), a holder (8) in which said container (1) is secured, and an optical fibre termination body (20) in which one end portion of an optical fibre tail (28) is inserted and secured, the axis of said end portion defining the axis of the fibre termination body (20), which body is provided with a wall (30) to which the fibre termination body axis extends normally, by which wall the fibre termination body is secured by a plurality of welds (W) to a co-operating wall (9) of the holder, wherein one of said walls is formed by a flange (20A), and wherein the normal to the end face (60) of said end portion of the optical fibre tail is inclined at an angle to the fibre termination axis, characterised in that the optical emission of the transducer (43) passes obliquely through the window (51) of the container (1) to be obliquely incident upon said inclined end face (60) of the fibre tail (28).

2. A fibre-tailed optical transmitter package as claimed in claim 1, wherein the optical termination body has two components parts (20, 20B) permanently secured together, which parts, before they were secured together, were adapted to slide one relative to the other so as to effect axial movement of the fibre tail (28) relative to the container (1).

## Patentansprüche

1. Gehäuseanordnung für einen mit einem Faserende versehenen optischen Sender, mit einem mit einem Fenster (51) versehenen, hermetisch abgedichteten Gehäuse (1), das einen lichtaussendenden elektro-optischen Wandler (43) enthält, mit einem Halter (8) , in dem das Gehäuse (1) befestigt ist, und mit Anschlußkörper (20) für eine optische Faser, in den ein Endteil eines optischen Faserendes (28) eingesetzt und befestigt ist, wobei die Achse dieses Endteils die Achse des Faser-Anschlußkörpers (20) bildet, der mit einer Wand (30) versehen ist, zu der sich die Achse des Faser-Anschlußkörpers senkrecht erstreckt, wobei der Faserabschlußkörper mit dieser Wand über eine Anzahl von Verschweißungen (W) an einer damit zusammenwirkenden Wand (9) des Halters befestigt ist, wobei eine der Wände durch einen Flansch (20A) gebildet ist, und wobei die Senkrechte zur Endfläche (60) des Endteils des optischen Faserendes unter einem Winkel zur Achse des Faser-Anschlußkörpers geneigt ist, dadurch gekennzeichnet, daß die Lichtemission des Wandlers (43) schräg durch das Fenster (41) des Gehäuses (1) verläuft, um schräg auf die geneigte Endfläche (60) des Faserendes (28) aufzutreffen.

2. Gehäuseanordnung für einen mit einem Faserende versehenen optischen Sender nach Anspruch 1, bei der der optische Anschlußkörper zwei Bestandteile (20,20B) aufweist, die dauerhaft miteinander verbunden sind, wobei die Bestandteile vor ihrer Befestigung aneinander relativ zueinander verschiebbar sind, um eine axiale Bewegung des Faserendes (28) gegenüber dem Gehäuse (1) zu bewirken.

## Revendications

1. Boîtier d'émetteur optique à liaison à fibre, comprenant un récipient hermétique (1) à fenêtre (51) qui contient un transducteur électro-optique (43) qui émet un faisceau optique, un organe de support (8) dans lequel est fixé le récipient (1), et un corps (20) de terminaison de fibre optique dans lequel une première partie d'extrémité d'une fibre optique (28) de liaison est introduite et fixée, l'axe de la partie d'extrémité formant l'axe du corps (20) de la terminaison, le corps ayant une paroi (30) à laquelle l'axe du corps de la terminaison est perpendiculaire, le corps de la terminaison étant fixé par cette paroi par plusieurs soudures (W) à une paroi coopérante (9) de l'organe de support, l'une des parois étant formée par un flasque (20A), et dans lequel la normale à la face (60) d'extrémité de la partie d'extrémité de la fibre optique de liaison est inclinée par rapport à l'axe de la terminaison optique, caractérisé en ce que l'émission optique du transducteur (43) passe obliquement à travers la fenêtre (51) du récipient (1) et tombe obliquement sur la face inclinée d'extrémité (60) de la fibre de liaison (28).

2. Boîtier d'émetteur optique à liaison à fibre selon la revendication 1, dans lequel le corps de la terminaison optique a deux éléments constituants (20, 20B) fixés de manière permanente l'un à l'autre, ces parties, avant leur fixation, étant destinées à glisser l'une par rapport à l'autre afin qu'elles assurent un déplacement axial de la fibre de liaison (28) par rapport au récipient (1).
